# EUROPEAN PATENT APPLICATION

(11) **EP 3 805 573 A1**
(43) Date of publication of application: **14.04.2021**
(21) Application number: 19920309.2
(22) Date of filing: 19.12.2019
(51) Int. Cl.: F04D 29/58, F04D 25/08, H05K 7/20

(54) **BLOWER HAVING HIGH HEAT DISSIPATION**

(30) Priority: 15.03.2019 CN 201910199496
(71) Applicant: KingClean Electric Co., Ltd., Suzhou New District Suzhou Jiangsu 215163 (CN)
(72) Inventor: NI, Zugen, Suzhou, Jiangsu 215163 (CN)
(74) Representative: Mewburn Ellis LLP
(86) International application number: PCT/CN2019/126727
(87) International publication number: WO 2020/186853

(57) **Abstract**

A hair dryer having high heat dissipation has a housing (1) and a heating component (2); an intake air blocking part is provided in the housing (1); the intake air blocking part is at least partially located in the air passage (11) of the hair dryer; at least part of intake air can flow through the heating component after the direction of the intake air is changed when the intake air passes through the intake air blocking part.

## Description

### TECHNICAL FIELD

The present disclosure relates to the technical field of home appliances, in particular, to a hair dryer with high heat dissipation.

### BACKGROUND

A hair dryer is a home appliance that uses hot air to dry wet objects. A structure for generating outlet air is a fan, and a structure for heating the outlet air is a heating wire. A structure for driving the fan to rotate is a motor.

A brushless motor is a kind of motor with relatively stable working condition. However, since a circuit board of the brushless motor (particularly a metal oxide semiconductor (MOS) transistor and a silicon controlled rectifier on the circuit board), when being used, will generate much heat, and it is not recommended to mount the circuit board directly in an air passage for a purpose of reducing noise, the brushless motor used in the hair dryer has poor heat dissipation effect and unstable working conditions, which restricts the application of the brushless motor in the hair dryer. The circuit boards of some hair dryers are made into the annular and are provided at an outer periphery surface of the air passage, so as to be cooled down by using inlet air. However, in such a structure, a contact area between the inlet air and the circuit board is insufficient, especially a portion of the circuit board on the leeward side is completely inaccessible to the inlet air, and thus the heat dissipation capacity of the circuit board is insufficient.

### SUMMARY

The present disclosure aims to provide a hair dryer of which a circuit board has an improved heat dissipation efficiency.

In order to achieve the above object, the present disclosure adopts the following technical solutions.

A hair dryer with high heat dissipation includes a housing and a heating component. The housing is provided with an inlet air blocking portion therein. The inlet air blocking portion is at least partially located in an air passage of the hair dryer. At least a part of an inlet air is capable of being changed in direction when passing through the inlet air blocking portion, and then flows through the heating component.

In particular, the air passage includes an air passage front section adjacent to an air inlet and an air passage rear section adjacent to an air outlet. The air passage front section is an annular space between the heating component and a motor. The air passage rear section is an annular space outside an inner cylinder adjacent to the air outlet. The inlet air blocking portion is located at a junction of the air passage front section and the air passage rear section.

In particular, the inlet air blocking portion is an end surface of the inner cylinder adjacent to the air inlet.

In particular, the inlet air blocking portion is provided with an air passing channel for a part of airflow entering the inner cylinder. The inner cylinder is provided with a functional element radiator and a functional air outlet therein.

In particular, a ratio of an outer diameter L of the motor to an inner diameter H of the inner cylinder is between 0.65 and 1.

In particular, the air passing channel includes an air passing inlet facing toward a direction of inletting air and an air passing outlet facing toward the heating component. The air passing inlet and the air passing outlet are separated from each other.

In particular, the air passing outlet faces toward a root of the heating component.

In particular, the inlet air blocking portion is a wind shielding surface disposed in the air passage. The wind shielding surface is a vertical surface or an inclined surface and is located on a side of the heating component away from an air inlet.

In particular, the wind shielding surface and the heating component are located on opposite sides of the air passage, respectively.

In particular, the heating component includes a circuit board.

At least a part of the inlet air in the hair dryer with high heat dissipation of the present disclosure may be changed in direction when passing through the inlet air blocking portion, and then flows through the heating component, so that heat on the heating component is taken away, thereby solving the problem that the heat dissipation effect of the circuit board in the conventional hair dryer is low, and improving the working stability of the hair dryer.

### BRIEF DESCRIPTION OF THE DRAWINGS

FIG. 1 is a cross-sectional view of a hair dryer according to an embodiment of the present disclosure.
FIG. 2 is an enlarged view of a portion A in FIG. 1.

In the drawings:
1- housing, 2- heating component, 3- motor, 4- inner cylinder, 5- heating wire, 6- air passing channel, 11- air passage, 41- functional element radiator, 42- functional air outlet, 111- air passage front section, 112- air passage rear section.

### DETAILED DESCRIPTION OF THE EMBODIMENTS

The technical solutions of the present disclosure will be further illustrated below in conjunction with the attached drawings and specific embodiments.

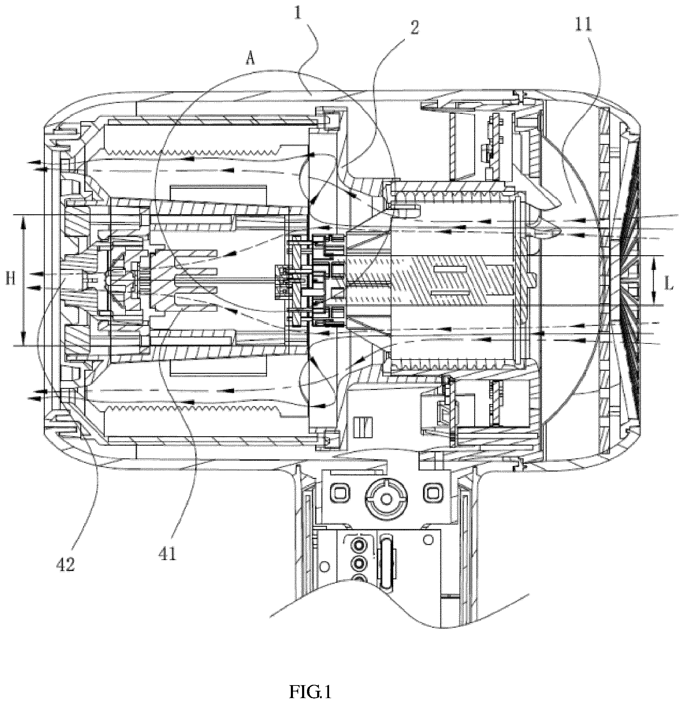

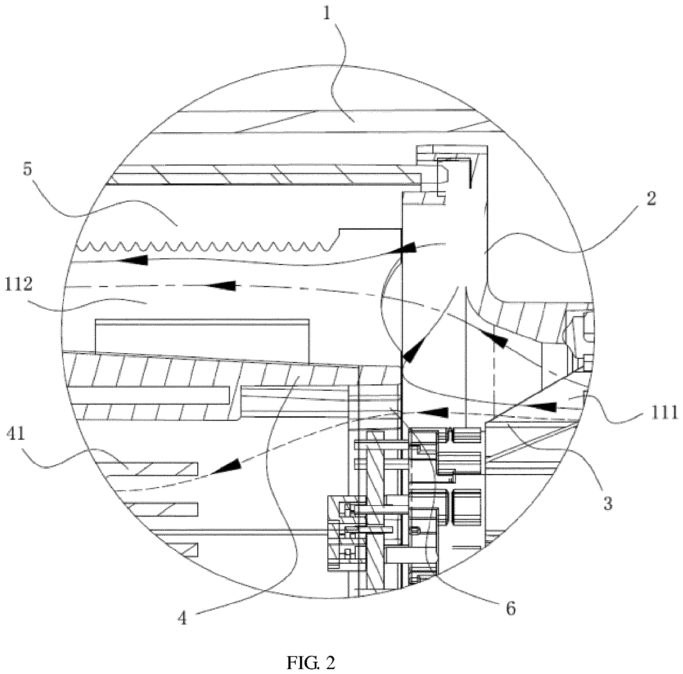

This embodiment discloses a hair dryer with high heat dissipation. As shown in FIGS. 1 and 2, the hair dryer includes a housing 1 and a heating component 2 disposed in the housing 1. The heating component 2 can be, but is not limited to, a circuit board of a motor, but is not a heating wire used for heating airflow in a conventional hair dryer. The housing 1 is provided with an inlet air blocking portion therein. The inlet air blocking portion is at least partially located in an air passage 11 of the hair dryer. After entering the air passage 11, the airflow is at least partially blocked by the inlet air blocking portion, and then changes the flowing direction, so as to blow toward the heating component 2 and take away heat from a surface of the heating component 2. In this way, the problem that a large amount of heat generated by the circuit board of the brushless motor is difficult to dissipate is solved.

The specific location of the inlet air blocking portion is not limited. Preferably, the air passage 11 includes an air passage front section 111 adjacent to an air inlet and an air passage rear section 112 adjacent to an air outlet. The air passage front section 111 is an annular space between the heating component 2 and a motor 3. The air passage rear section 112 is an annular space outside an inner cylinder 4 adjacent to the air outlet (an outer wall of the inner cylinder 4 is mounted with a plurality of heating wire supports 5. The heating wire supports 5 extend along a direction of the inletting air, and the airflow passes through between the heating wire supports 5). The inlet air blocking portion is located at a junction of the air passage front section 111 and the air passage rear section 112. Such the junction is relatively close to the heating component 2, and thus the airflow whose blowing direction has been changed can blow onto the heating component 2 easily and take away more heat.

The inlet air blocking portion is preferably an end surface of the inner cylinder 4 adjacent to the air inlet. Since a diameter of the inner cylinder 4 is larger than a diameter of the motor 3, a part of the inlet air will impinge on the end surface of the inner cylinder 4, as shown by a solid line with arrows in FIGS. 1 and 2, and thus the flowing route of the part of the inlet air will be changed. That is, this part of the airflow is diverted, and directly blows onto a leeward surface and a root of the heating component 2. Then, the airflow carrying the heat generated by the heating component 2 is then blocked and diverted by the heating component 2, and then blows out from the air outlet of the hair dryer together with a normal airflow (shown by a dotted line with arrows in the figures).

In the above process, the diverted airflow can be diverted again after impinging on the leeward surface or the root of the heating component 2 and flows toward the air outlet, causing a certain degree of negative pressure to be generated at the root of the heating component 2. Thus, more air may be forced to flow through the root to take away the heat on the heating component 2 and reduce the temperature of the heating component 2.

The end surface of the inner cylinder 4 (i.e., the inlet air blocking portion) is provided with an air passing channel 6 through which a part of the airflow enters the inner cylinder 4. The inner cylinder 4 is provided with a functional element radiator 41, a functional air outlet 42, and a functional element (not shown in the figures) therein. The functional element can be, but is not limited to, a water droplet generator and a negative ion generator. Another part of the inlet airflow of the hair dryer will enter the inner cylinder 4 through the air passing channel 6, as shown by the dotted line with arrows in FIGS. 1 and 2. This part of the airflow continues to flow forwards in the inner cylinder 4 for a certain distance, passes through the functional element and then blows out from the functional air outlet 42. The airflow blowing out from the functional air outlet 42 carries water droplets and/or negative ions, which improves the function of the hair dryer.

A width of the air passing channel 6 and a width of the end surface of the inner cylinder 4 are not limited, as long as the inlet airflow can smoothly flow into the air passing channel 6 and the flowing direction of the inlet air can be changed when inlet airflow is blocked. Preferably, a ratio of an outer diameter L of the motor 3 to an inner diameter H of the inner cylinder 4 is between 0.65 and 1. In this way, a proper proportion of the entire original airflow will enter the inner cylinder 4, and a sufficient amount of functional air carrying water droplets and/or negative ions therefore can be generated. In addition, another part of the airflow is diverted after being blocked and then flows toward the heating component 2, without affecting normal use of the hair dryer.

Preferably, the air passing channel 6 includes an air passing inlet facing the direction of the inletting air and an air passing outlet facing the heating component 2. The air passing inlet and the air passing outlet are separated from each other. A part of the original airflow enters the inner cylinder 4 through the air passing inlet, and blows out from the air passing outlet after impinging on the functional element radiator 41. The inlet air and the outlet air will not collide with each other at the air passing channel 6. Thus, a situation that the airflow stays in the inner cylinder 4 for a long time caused by dispersion of the airflow after impinging on the functional element radiator 41 can be avoided, which affects the subsequent air inflow.

The air passing outlet preferably faces toward the root of the heating component 2. The root of the heating component 2 is away from a center of the air passage 11, and is a structure that is most difficult to be cooled down in the existing device. In the present disclosure, the airflow blowing out from the air passing outlet and the airflow diverted after being blocked by the inlet air blocking portion can directly flow toward the root of the heating component 2, which can take away heat from the root to the greatest extent, and the cooling effect is significantly improved.

Of course, the structure of the inlet air blocking portion is not limited to the above form, and may also be a wind shielding surface disposed in the air passage 11. The wind shielding surface is a vertical surface or an inclined surface and is located on a side of the heating component 2 away from the air inlet. A part of the airflow impinges on the wind shielding surface and then is diverted, then flows through the surface of the heating component 2, and then blows out from the air outlet. In order to allow more airflow to blow directly onto the leeward surface and the root of the heating component 2, preferably, the wind shielding surface and the heating component 2 are located on opposite sides of the air passage 11, respectively.

Note that the above contents are only the preferred embodiments of the present disclosure and the technical principles applied. Those skilled in the art will understand that the present disclosure is not limited to the specific embodiments described herein. Various obvious changes, readjustments and substitutions can be made to the embodiments by those skilled in the art, without departing from the protection scope of the present disclosure. Therefore, although the present disclosure has been described in more detail through the above embodiments, the present disclosure is not limited to the above embodiments, and can further include more other equivalent embodiments without departing from the concept of the present disclosure. The scope of the present disclosure shall subject to the scope of the appended claims.

## Claims

1. A hair dryer with high heat dissipation, comprising a housing (1) and a heating component (2), wherein the housing (1) is provided with an inlet air blocking portion therein, the inlet air blocking portion is at least partially located in an air passage (11) of the hair dryer, and at least a part of an inlet air is capable of being changed in direction when passing through the inlet air blocking portion, and then flows through the heating component (2).

2. The hair dryer with high heat dissipation according to claim 1, wherein the air passage (11) comprises an air passage front section (111) adjacent to an air inlet and an air passage rear section (112) adjacent to an air outlet, the air passage front section (111) is an annular space between the heating component (2) and a motor (3), the air passage rear section (112) is an annular space outside an inner cylinder (4) adjacent to the air outlet, and the inlet air blocking portion is located at a junction of the air passage front section (111) and the air passage rear section (112).

3. The hair dryer with high heat dissipation according to claim 2, wherein the inlet air blocking portion is an end surface of the inner cylinder (4) adjacent to the air inlet.

4. The hair dryer with high heat dissipation according to claim 2, wherein the inlet air blocking portion is provided with an air passing channel (6) for a part of airflow entering the inner cylinder (4), and the inner cylinder (4) is provided with a functional element radiator (41) and a functional air outlet (42) therein.

5. The hair dryer with high heat dissipation according to claim 4, wherein a ratio of an outer diameter L of the motor (3) to an inner diameter H of the inner cylinder (4) is between 0.65 and 1.

6. The hair dryer with high heat dissipation according to claim 4, wherein the air passing channel (6) comprises an air passing inlet facing toward a direction of inletting air and an air passing outlet facing toward the heating component (2), and the air passing inlet and the air passing outlet are separated from each other.

7. The hair dryer with high heat dissipation according to claim 6, wherein the air passing outlet faces toward a root of the heating component (2).

8. The hair dryer with high heat dissipation according to claim 1, wherein the inlet air blocking portion is a wind shielding surface disposed in the air passage (11),
the wind shielding surface is a vertical surface or an inclined surface and is located on a side of the heating component (2) away from an air inlet.

9. The hair dryer with high heat dissipation according to claim 8, wherein the wind shielding surface and the heating component (2) are located on opposite sides of the air passage (11), respectively.

10. The hair dryer with high heat dissipation according to any one of claims 1 to 8, wherein the heating component (2) comprises a circuit board.
